Europäisches Patentamt

European Patent Office

Office européen des brevets

(11) Publication number: 0 208 492
A2

# EUROPEAN PATENT APPLICATION

(21) Application number: 86305061.3

(51) Int. Cl.⁴: H 05 K 13/04

(22) Date of filing: 30.06.86

(30) Priority: 12.07.85 GB 8517703
12.02.86 GB 8603485

(43) Date of publication of application:
14.01.87 Bulletin 87/3

(84) Designated Contracting States:
AT DE FR GB IT NL

(71) Applicant: AB Electronic Components Limited
Abercynon
Mountain Ash Mid-Glamorgan CF45 4SF Wales(GB)

(72) Inventor: Golten, Desider
48 Beulah Road
Cardiff Wales CF4 6LX(GB)

(74) Representative: Smith, Geoffrey Leonard et al,
MARKS & CLERK Friars House 6 - 10 Parkway
Chelmsford Essex CM2 0NF(GB)

(54) Assembly of surface mounted components.

(57) A method of assembling a surface-mounted component (5) onto a substrate, comprising applying a deposit of solder cream to the substrate, preheating to boil off volatile material from the solder cream, and securing the component (5) by adhesive to the substrate prior to a reflow stage to solder the component (5) to the substrate, wherein the component (5) is supplied as part of a stream of such components by a carrying medium (2, 10), in which the adhesive is applied to the component (5) through cut-outs (7) immediately prior to its location on the substrate. The application of the adhesive to the component, rather than to the board, cuts out a step in the processing of the substrate. The carrying medium may be a composite paper tape consisting of three layers (1,2,3), a flexible multiple blister pack consisting of two layers (1, 10), each of which has multiple cut-outs (7), or a magazine having a single cut-out. When the components (5) are placed on the printed circuit board in their assigned position the adhesive achieves a secure mechanical bond between the board and the components thus preventing the components from moving, lifting or being blown off during the course of the reflow operation when components are fused by molten solder to the printed circuit board.

FIG.1.

FIG.9.

EP 0 208 492 A2

0208492

P10094EP

## ASSEMBLY OF SURFACE-MOUNTED COMPONENTS

This invention relates to surface mounted assemblies, such as electronic printed circuit boards.

In surface mounted assembly the printed circuit board receives a deposit of solder cream in the required position and of the correct quantity and shape. The components which make up the complete printed circuit board are collected from a paper tape, a plastics blister pack or a magazine and placed in their assigned position which has already had the solder cream deposit applied thereto. The solder cream itself consists of finely ground globules of a zinc/lead alloy mixed with various fluxes and solvents to give the cream its required properties. These solvents boil off at relatively low temperatures in a pre-heat sequence prior to application of the components. However a residue of these solvents tends to be retained in the solder cream. This residue evaporates violently during the reflow sequence when the temperatures reach high enough levels to melt the solder alloy, allowing it to fuse with the components and so ensuring that the components are attached to the circuit board. This violent evaporation combined with mechanical disturbances may cause some of the components to move, lift or be blown off the board, thus producing open circuits, short circuits or other faults which have to be subsequently and manually repaired.

The accepted method of overcoming this problem is to apply adhesive to the printed circuit board in the required area and then to bring the components to that position, thus achieving an adhesive bond prior to the reflow sequence.

According to a first aspect of the present invention there is provided a method of assembling a surface-mounted component onto a substrate, comprising applying a deposit of solder cream to the substrate, preheating to boil off volatile material from the solder cream, and securing the component to the substrate by adhesive prior to a reflow stage to solder the component to the substrate, wherein the component is supplied as part of a stream of such components by a carrying medium, in which the adhesive is applied to the component immediately prior to its location on the substrate.

The carrying medium preferably has a cut-out beneath part of each component and the adhesive is applied to the required part of the component through the said cut-out.

The carrying medium may be a composite paper tape having one layer with apertures forming receptacles for the components, and a subjacent layer having the cut-outs through which adhesive is supplied, while still retaining support of the component within the receptacle.

In one alternative, the carrying medium includes a multiple flexible blister pack having receptacles for the components, the receptacles having cut-outs through which adhesive is supplied, while still retaining support of the component within the receptacle.

As a further alternative, the carrying medium is a magazine through which the components are transported, and including a single aperture across which the components pass seriatim during transport and constituting a cut-out through which adhesive is supplied, while still retaining support of the component within the magazine.

In accordance with a further aspect of the invention, there is provided apparatus for transporting a flexible transport medium for components to be presented seriatim in a required orientation and secured to substrates, in which the carrying medium has a cut-out beneath part of each component, and in which the apparatus includes means for applying adhesive to a required part of the component through the said cut-out, and means for immediately subsequently transferring the component to the substrate.

A particular advantage of the invention is that since the adhesive is applied directly to the underside of the components, i.e. not to the board, a step in the treatment of the board or other substrate is avoided. So far as treatment of the substrate is concerned, the application of the component and its adhesive are simultaneous. In addition, the adhesive is applied to the component immediately prior to the location of the component on the substrate. Since the components are supplied as a stream, the operation of transferring one component may be carried out simultaneously with the application of adhesive to the succeeding component in the stream so that a minimum of time is occupied in preparing the components and applying them to the substrates.

Specific embodiments of this invention will now be described with reference to the accompanying diagrammatic drawings, in which:

Figure 1 shows an isometric view of a paper tape;

Figures 2, 3, 4, 5, 6, and 7 show various shapes for cut-outs in a support tape viewed in the direction of arrows M and N of figure 1;

Figure 8 shows an isometric view of a plastic blister pack;

Figures 9, 10, 11, 12, 13 and 14 show various shapes for cut-outs in a blister pack viewed in the direction of arrows X and Y of figure 8;

Figure 15 shows an isometric view of a typical magazine;

Figure 16 shows a plan view of the magazine of figure 15;

Figure 17 shows a cross-section of the magazine taken on the line A-A of figure 16;

Figure 18 shows a cross-section of the magazine taken on the line B-B of figure 16; and

Figure 19 shows a schematic lay-out of a reel feeder.

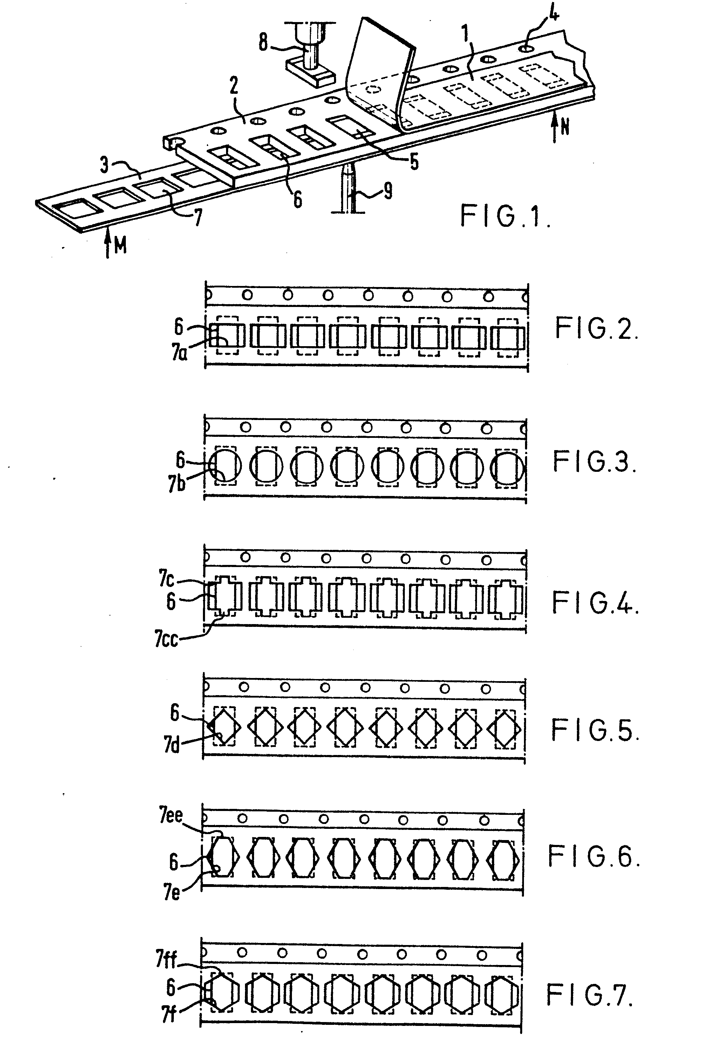

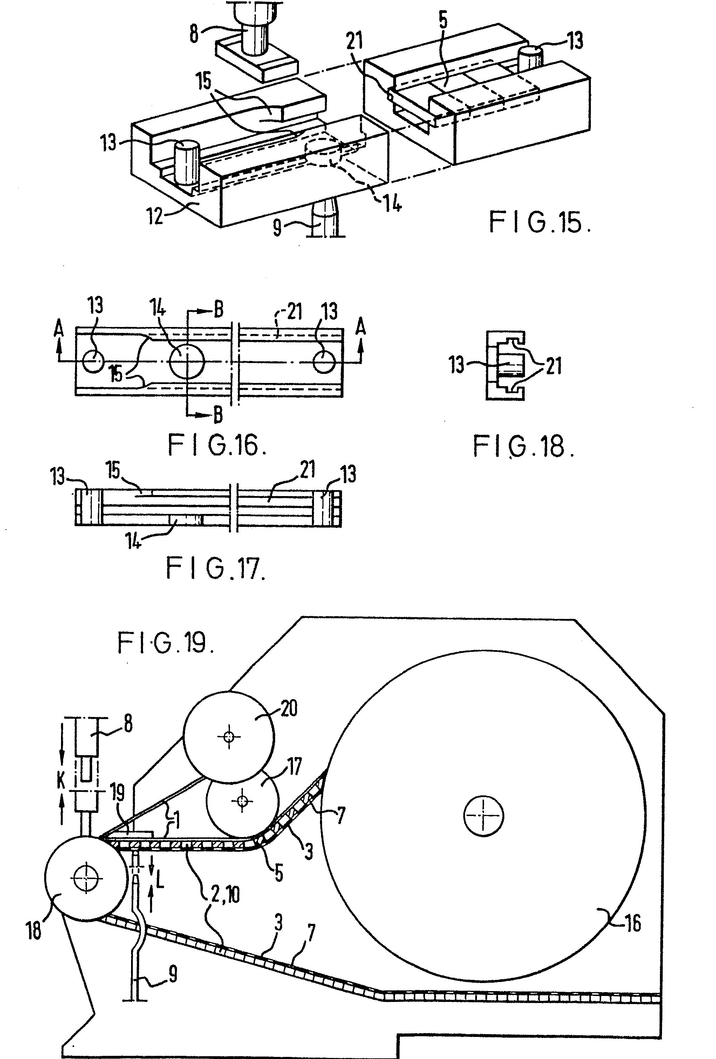

Referring first to figure 1, a paper tape consists of three layers. The first layer is a transparent cover film 1 which enables the components 5 to be visible for identification and which prevents the components 5 falling out. The second layer is a transporting tape 2 which has recesses, forming receptacles 6, cut out in it. The tape 2 transports the components 5 and also has indexing holes 4 for correct positioning of the tape by means of a sprocket wheel 18 (see figure 19) in relation to a collecting head 8 and an adhesive dispenser 9. The third layer is a support tape 3 which supports the components 5 in the receptacles 6 in the transporting tape 2 and is provided with cut-outs 7, one associated with each receptacle 6. These cut-outs can be any of a variety of shapes as shown in figures 2, 3, 4, 5, 6 and 7 and enable the adhesive dispenser 9 to apply adhesive to the underside of the components 5 through these cut-outs while preventing the said components 5 from dropping out.

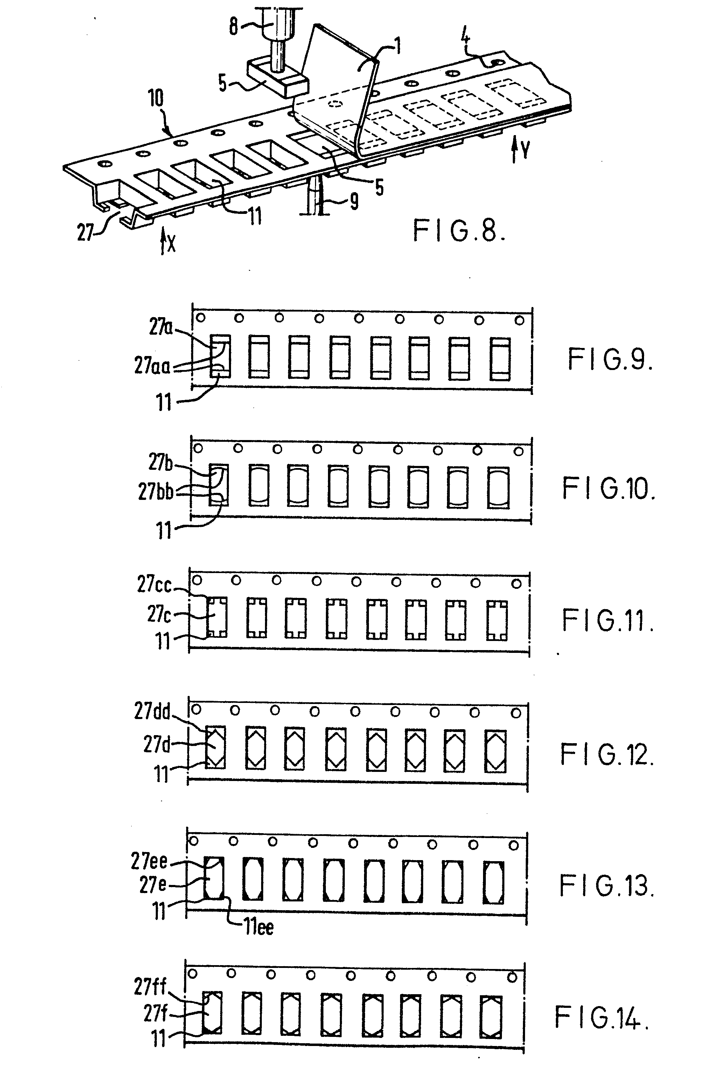

It will be seem that figure 2 shows the use of rectangular cut-outs 7a while figure 3 shows circular cut-outs 7b. The arrangement of figure 4 is of a rectangular cut-out 7c with extensions 7cc to take it the full length of the receptacle 6, thus forming an essentially cruciform cut-out. Figure 5 shows square cut-outs 7d set diagonally and figure 6 shows elongate hexagonal cut-outs 7e with the two short sides 7ee lying along the ends of the receptacle 6. Figure 7 shows the use of regular hexagonal cut-outs 7f with an apex 7ff lying substantially centrally at each end of the receptacle 6.

Turning now to figure 8, the carrying tape in this embodiment is manufactured as a flexible blister pack 10 of a suitable plastics material. The pack 10 has cavities 11 to carry the components 5, and again has indexing holes 4 to register its position accurately in respect of the collecting head 8 and the adhesive dispenser 9. In this case, cut-outs 27 are provided in the bases of the cavities 11 to allow the adhesive dispenser 9 to apply adhesive to the underside of the components 5 and again the transparent cover film 1 allows the components 5 to be identified and prevents them from dropping out. The cut-outs 27 can have a variety of shapes as shown in figures 9, 10, 11, 12, 13 and 14 to enable the dispenser to apply the adhesive through these cut-outs 27 to the undersides of the components 5 while preventing the components 5 from dropping out.

In this case, the cut-outs are formed in the bases of the cavities 11, so they cannot extend beyond the confines of these bases. In figure 9, the cut-out 27a is shown as being defined between two edges 27aa which are straight and parallel with the ends of the cavity 11. In figure 10, the cut-outs 27b are similar to the cut-outs 27a, but have curved end edges 27bb. In figure 11, the cut-outs 27c are similar to the cut-outs 27a, but have been extended onto cruciform shape so as to cover all but corner areas 27cc of the base of the cavity 11.

In figure 12, the cut-outs 27d are formed essentially by oblique edges 27dd. In figure 13, the cut-outs 27e again leave only corner portions 11ee of each cavity base, being defined by edges 27ee steeply inclined to the end of the cavity 11. Figure 14 shows cut-outs 27f similar to those shown in figure 13 except that the edges 27ff are less steeply inclined to the ends of the cavities 11.

Figures 15 to 18 show a typical magazine feeder. A main body 12 may be made of metal or plastics or similar materials and has a groove 21 (see particularly figure 18) which carries components 5 toward the collecting head 8. On each end of the magazine are stops 13 preventing the components 5 from falling out. The groove 21 is machined out in the region of an opening 15 to allow the collecting head 8 to pick up components 5 and just prior to the collecting position a hole 14 is provided through the base of the magazine body 12 to allow the adhesive dispenser 9 to apply adhesive to the underside of the component 5 and yet to prevent the components from falling out.

Both paper tapes and blister packs come on reels and figure 19 shows a schematic lay-out of a typical reel feeder. A reel 16 feeds a complete paper tape 1, 2, 3 or a blister pack 1, 10 over a guide wheel 17 to an indexing sprocket wheel 18. The cover film 1 is removed at block 19 and wound onto a wheel or reel 20 to be disposed of at a later stage. The adhesive dispenser 9 applies a suitable glue to the undersides of components 5 through the cut-outs 7, and the head 8 then immediately collects the components 5 from the carrying tape and places them in the required position. The adhesive dispenser 9 reciprocates in the direction of arrow L to allow the tape to be transported by one step to the collecting head 8, which head collects the component initially in a vertical direction as indicated by arrow K before moving horizontally to the required position.

Thus, acccrding to the present invention, the adhesive is applied to the component immediately prior to the components 5 being picked up by the collecting head 8, so making the application of the adhesive or glue to the component and placement of the component into a co-ordinated single operation (or a simultaneous pair of operations), rather than the adhesive being applied to the printed circuit board which is essentially a cycle of two separate operations.

Various modifications may be made within the scope of the invertion as defined in the appended claims. For instance, the adhesive may be applied by any suitable means, such as a nozzle, spray device, glue dispensing wheel, spikes of a sprocket wheel or the like.

CLAIMS

1. A method of assembling a surface-mounted component (5) onto a substrate, comprising applying a deposit of solder cream to the substrate, preheating to boil off volatile material from the solder cream, and securing the component (5) by adhesive to the substrate prior to a reflow stage to solder the component (5) to the substrate, wherein the component (5) is supplied as part of a stream of such components by a carrying medium (2,10,12), characterised in that the adhesive is applied to the component (5) immediately prior to its location on the substrate.

2. A method according to claim 1, characterised in that the carrying medium (2,10) has a cut-out (7,27) beneath part of each component and the adhesive is applied to the required part of the component through the said cut-out (7,27).

3. A method according to claim 2, characterised in that the carrying medium is a composite paper tape having one layer (2) with apertures forming receptacles (6) for the components (5), and a subjacent layer (3) having cut-outs (7) through which adhesive is applied, while still retaining support of the component (5) within the receptacle (6).

4. A method according to claim 2, characterised in that the carrying medium includes a multiple blister pack (10) having receptacles (11) for the components (5), the receptacles (11) having cut-outs (27) through which adhesive is applied, while still retaining support of the component (5) within the receptacle (11).

5. A method according to claim 1, characterised in that the carrying medium is a magazine (12) through which the components (5) are transported, and including a single aperture (14) across which the components (5) pass seriatim during transport and constituting a cut-out through which adhesive is supplied, while still retaining support of the component (5) within the magazine (12).

6. A method according to any of the preceding claims, characterised in that the substrate is a printed circuit board.

7. Apparatus for transporting a flexible transport medium for components (5) to be presented seriatim in a required orientation and secured to substrates, characterised in that the carrying medium has a cut-out (7,27) beneath part of each component (5), and in that the apparatus includes means (9) for applying adhesive to a required part of the component (5) through the said cut-out (7,27), and means (8) for immediately subsequently transferring the component to the substrate.

020849

FIG.1.

FIG.2.

FIG.3.

FIG.4.

FIG.5.

FIG.6.

FIG.7.

FIG.8.

FIG.9.

FIG.10.

FIG.11.

FIG.12.

FIG.13.

FIG.14.

0208492

FIG.15.

FIG.16.

FIG.18.

FIG.17.

FIG.19.